# EUROPÄISCHE PATENTSCHRIFT

(11) **EP 2 328 391 B1**
(45) Veröffentlichungstag und Bekanntmachung des Hinweises auf die Patenterteilung: **27.05.2015**
(21) Anmeldenummer: 10014504.4
(22) Anmeldetag: 11.11.2010
(51) Int. Cl.: H05K 1/14, H02M 7/00

(54) **Umrichter**
Converter
Convertisseur

(30) Priorität: 19.11.2009 DE 102009053997
(43) Veröffentlichungstag der Anmeldung: 01.06.2011
(73) Patentinhaber: STILL GmbH, 22113 Hamburg (DE)
(72) Erfinder: Wilhoeft, Adolf, 22885 Barsbüttel (DE); Schmidt, Niels, 22885 Barsbüttel (DE); Schettgen, Nils Christoph, 22609 Hamburg (DE)
(74) Vertreter: Geirhos, Johann

(56) Entgegenhaltungen:
- EP-A1- 0 998 019
- EP-A1- 1 359 662
- EP-A2- 0 711 107
- EP-A2- 1 696 546
- WO-A2-03/034467
- GB-A- 2 336 254
- US-A- 5 774 353
- US-A1- 2005 152 100

## Beschreibung

Die Erfindung betrifft einen Umrichter, insbesondere mehrphasiger Drehstromumrichter, mit einem Gleichspannungszwischenkreis und einem mindestens einen Leistungshalbleiter aufweisenden Leistungsmodul, wobei der Gleichspannungszwischenkreis von einer plattenförmigen Platine und das Leistungsmodul von einer Leiterplatte gebildet sind, die in parallelen Ebenen direkt übereinander angeordnet sind und mittels Lötstiften elektrisch und mechanisch miteinander verbunden sind.

Derartige mehrphasige Umrichter, beispielsweise dreiphasige Wechselrichter oder Frequenzumrichter, werden zur Speisung von elektrischen Antriebsmaschinen aus einer Gleichspannungsquelle verwendet. Eingesetzt werden derartige Umrichter beispielsweise als Frequenzumrichter, die aus einer Gleichspannungsquelle einen Fahrmotor, beispielsweise einen Asynchronmotor, eines mobilen elektrisch betriebenen Fahrzeugs, beispielsweise eines Flurförderzeugs, ansteuern.

Die Gleichspannung kann aus einer Batterie oder einem Generator als Gleichspannungsquelle bereitgestellt werden. Als Generator kann ein Gleichspannungsgenerator oder ein Drehstromgenerator eingesetzt werden, dessen erzeugter Drehstrom in einem Gleichrichter gleichgerichtet wird.

Ein gattungsgemäßer Umrichter ist aus der EP 1 083 599 B1 bekannt. Der elektrische Gleichspannungszwischenkreis ist von einer Leiterplatte gebildet, die oberhalb eines Leistungsmoduls angeordnet ist. Das Leistungsmodul besteht aus mehreren identisch aufgebauten rechteckförmigen Substraten, die an den Längsseiten mit elektrischen Kontaktflächen versehen sind. Die Substrate werden nebeneinander derart angeordnet, dass zwei nebeneinander liegende Kontaktflächen zweier benachbarter Substrate auf demselben Potential liegen und durch eine Anpressvorrichtung in Form von elektrisch leitenden Druckstücken elektrisch kontaktiert werden können. Die Druckstücke dienen weiterhin zur Anpressung der Substrate an einen Kühlkörper, um eine Kühlung der Leistungshalbleiter sicherzustellen.

Die Kontaktsicherheit von derartigen Druckkontaktaufbauten ist bei Dauer- oder Wechsellastbetrieb von entscheidender Bedeutung für die Funktionssicherheit. Bei Druckstücken kann durch Erlahmen der Druckkräfte eine Funktionsstörung des Umrichters auftreten.

Bei derartigen Umrichern ist als weitere Randbedingung ein möglichst induktivitätsarmer Aufbau erwünscht. Das Schalten der Leistungshalbleiter des Leistungsmoduls wird durch Streuinduktivität, die aus den Weglängen des mechanischen Aufbaus zwischen Gleichstromzwischenkreis und den Leistungshalbleitern des Leistungsmoduls resultieren, erschwert. Diese Streuinduktivität verschlechtert das Schaltverhalten der Leistungshalbleiter und kann zu Überspannungen, die zu einer Zerstörung der Leistungshalbleiter führen können, und erhöhten Schaltverlusten führen. Ursache ist die in der Streuinduktivität, durch großes di/dt erzeugte Selbstinduktionsspannung, welche sich der Zwischenkreisspannung überlagert und zu unzulässig hohen Spannungen und entsprechenden Spannungsspitzen an den Leistungshalbleitern führen kann.

Aus der oben genannten EP 1 083 599 B1 ist hierzu bereits bekannt, einen induktivitätsarmen Aufbau dadurch zu erzielen, dass der Gleichspannungszwischenkreis in Form einer Leiterplatte direkt über den Substraten des Leistungsmoduls mit geringem Abstand angeordnet ist, wobei die Druckstücke zwischen der Leiterplatte des Gleichspannungszwischenkreises und den Substraten des Leistungshalbleiter des Leistungsteils angeordnet sind. Aufgrund der Mehrzahl der Substrate des Leistungsmoduls, deren Anordnung und der Mehrzahl der Druckstücke weist der aus der EP 1 083 599 B1 bekannte Umrichter jedoch einen hohen Bauaufwand und Montageaufwand auf, wobei durch die Druckstücke weiterhin bei einem Dauer- oder Wechsellastbetrieb Funktionsstörungen des Umrichters auftreten können.

Ein Umrichter nach dem Oberbegriff des Patentanspruchs 1 ist aus der EP 1 359 662 A1 bekannt.

Aus der US 5,774,353 A ist ein Umrichter mit einer Steuerung und einer Platine für Leistungsbausteine bekannt, die in parallelen Ebenen angeordnet sind.

Aus der EP 0 998 019 A1 und aus der GB 2 336 254 A sind Umrichter mit Leistungsbauelementen und einer oberhalb von diesen angeordneten Platine für Kondensatoren bekannt, wobei L-förmige Verbindungselemente mithilfe eines an den kurzen Schenkel angelöteten Drahtes eine Verbindung zwischen den Leistungsbauelementen und der Platine herstellen.

Weitere Umrichter sind aus der WO 03/034467 A2 und der EP 0 711 107 A2 bekannt.

Der vorliegenden Erfindung liegt die Aufgabe zugrunde, einen Umrichter der eingangs genannten Gattung zur Verfügung zu stellen, dessen mechanischer Aufbau hinsichtlich der Streuinduktivität weiter verbessert ist und der einen kostengünstigen Aufbau mit geringem Montageaufwand aufweist.

Diese Aufgabe wird erfindungsgemäß durch einen Umrichter nach Anspruch 1 gelöst, bei welchem der Gleichspannungszwischenkreis von einer plattenförmigen Platine und das Leistungsmodul von einer Leiterplatte gebildet sind, die in parallelen Ebenen direkt übereinander angeordnet sind und mittels Lötstiften elektrisch und mechanisch miteinander verbunden sind. Erfindungsgemäß sind die Leistungsstromanschlüsse des Leistungsmoduls von Stromschienen gebildet, die über mindestens einen Metallkörper mit der Leiterplatte elektrisch verbunden sind, und die Stromschienen oberhalb der Platine angeordnet, wobei sich der Metallkörper durch eine Ausnehmung der Platine erstreckt. Der Aufbau des Umrichters aus einer Platine des Gleichspannungszwischenkreises und einer Leiterplatte des Leistungsmoduls ergibt einen einfachen Aufbau mit wenigen Bauteilen, wobei die stromführenden Verbindungsleitungen von entsprechenden niederinduktiven Leiterbahnen in der Leiterplatte und der Platine mit kurzen Weglängen gebildet werden können. Die Lötstifte weisen bei dem erfindungsgemäßen Umrichter eine Doppelfunktion auf und dienen neben der elektrischen Kontaktierung der Platine des Zwischenkreises mit der Leiterplatte des Leistungsmoduls weiterhin zur mechanischen Befestigung der Platine des Zwischenkreises an der Leiterplatte des Leistungsmoduls. Die Lötstifte sind zumindest mit der Platine des Gleichspannungszwischenkreises und der Leiterplatte des Leistungsmoduls verlötet. Die Leiterplatte des Leistungsmoduls und die Platine des Gleichspannungszwischenkreises können somit als Vormontagebaugruppe ausgebildet werden. Hierdurch wird ein einfacher und kostengünstiger Aufbau ohne zusätzliche Befestigungsmittel erzielt und eine einfache Montage des erfindungsgemäßen Umrichters erzielt. Durch die Anordnung der Platine des Zwischenkreises und der Leiterplatte des Leistungsmoduls direkt übereinander und der Verwendung der Lötstifte zur mechanischen und elektrischen Verbindung kann der Abstand zwischen dem Gleichspannungszwischenkreis und dem Leistungsmodul gegenüber bekannten Umrichteraufbauten weiter verringert werden. Im Gegensatz zu einer Druckkontaktierung ist die Kontaktierung mittels Lötstiften im Dauer- oder Wechsellastbetrieb, vor allem im thermischen Wechsellastbetrieb, über die Lebensdauer des Umrichters funktionssicher. Zudem kann der für die Streuinduktivitäten verantwortliche Abstand zwischen der Platine des Gleichspannungszwischenkreises und der Leiterplatte des Leistungsmoduls durch die Verwendung von Lötstiften zur Kontaktierung im Vergleich zu einer Druckkontaktierung mit Druckstücken weiter minimiert werden. Darüber hinaus weisen Lötstifte einen einfachen Aufbau mit geringem Herstellaufwand auf und können auf einfache Weise an der Oberseite der Leiterplatte des Leistungsmoduls bzw. an der Unterseite der Platine des Gleichspannungszwischenkreises montiert werden, insbesondere vollautomatisch bestückt werden, wodurch der Herstellaufwand und die Montage des erfindungsgemäßen Umrichters vereinfacht wird. Der Aufbau des Umrichters lässt sich hinsichtlich einer kostengünstigen Bauweise und einer einfachen Montage weiter verbessern, wenn die Leistungsstromanschlüsse des Leistungsmoduls von Stromschienen gebildet sind, die über mindestens einen Metallkörper mit der Leiterplatte elektrisch verbunden sind. Die Leistungsstromanschlüsse des Leistungsmoduls und somit die Motorphasenabgänge können von Stromschienen mit geringem Bauaufwand gebildet werden. Sofern die Stromschienen oberhalb der Platine angeordnet sind und sich der Metallkörper durch eine Ausnehmung der Platine erstreckt, kann eine platzsparende Anordnung der Stromschienen in einer weiteren parallelen Ebene oberhalb der Platine des Gleichspannungszwischenkreises erzielt werden.

Hinsichtlich eines einfachen Bauaufwandes und einer einfachen Montage ergeben sich Vorteile, wenn die Lötstifte gemäß einer bevorzugten Ausgestaltungsform der Erfindung an der der Platine zugewandten Oberseite der Leiterplatte montiert sind und sich durch Aufnahmebohrungen der Platine erstrecken, wobei die Lötstifte einen Durchmesserabsatz zur Halterung der Platine aufweisen. Die Lötstifte können hierbei mit der Leiterplatte verlötet oder verpresst sein, um mit den stromführenden Leiterbahnen der Leiterplatte des Leitungsmoduls kontaktiert zu werden. Der Durchmesserabsatz an den Lötstiften ermöglicht hierbei eine einfache Montage und Befestigung der Platine des Gleichspannungszwischenkreises, da die Platine des Gleichspannungszwischenkreises mit den Aufnahmebohrungen auf einfache Weise auf die Lötstifte aufgesteckt und gehaltert werden kann.

Die Leiterplatte ist gemäß einer bevorzugten Ausführungsform der Erfindung als IMS-(Insulated-Metal-Substrate) Leiterplatte ausgebildet, die mit den Leistungshalbleitern bestückt ist. Bei einer derartigen IMS-Leiterplatte können die stromführenden Leiterbahnen zur Verbindung der Lötstifte mit Anschlüssen der Leistungshalbleiter induktionsarm geführt werden und als Dickschichtmetallbahnen für den Wärmeabtransport genutzt werden. Zudem kann eine derartige IMS-Leiterplatte auf einfache Weise mit den Leistungshalbleitern und weiteren diskreten Bauelementen sowie den Lötstiften bestückt werden.

Bevorzugt sind hierbei die Stromschienen zwischen Kondensatoren des Gleichspannungszwischenkreises angeordnet, die an der Platine angeordnet sind, wodurch sich eine platzsparende und bauraumsparende Anordnung der Stromschienen innerhalb der Bauhöhe der Kondensatoren des Gleichspannungszwischenkreises erzielen lässt.

Gemäß einer vorteilhaften Weiterbildung der Erfindung ist die Stromschiene in einem seitlich neben der Platine angeordneten Bereich mit einem Anschluss, insbesondere einem Bolzen, für einen Leistungsstromabgriff versehen. Die Stromschienen der Leistungsstromanschlüsse können durch die Anordnung zwischen den Kondensatoren des Gleichstromzwischenkreises auf einfache Weise seitlich aus der Platine herausgeführt werden und in dem seitlich herausgeführten Bereich mit einem Anschluss als Motorphasenabgänge versehen werden. Hierdurch ergibt sich bei geringem Bauaufwand eine gute Zugänglichkeit für die Motorphasenabgänge, an denen entsprechende Motorkabel sicher und bei guter Zugänglichkeit angeschlossen werden können.

Hinsichtlich eines geringen Bauraumbedarfs sind weitere Vorteile erzielbar, wenn die Stromschiene im Bereich des Anschlusses in Richtung zu der Platine abgekröpft ist. Bei den oberhalb der Platine angeordneten Stromschienen kann durch eine entsprechende Abkröpfung nach unten in Richtung der Platine eine Anordnung der von den beispielsweise als Bolzen ausgebildeten Anschlüssen in bauraumsparender Weise innerhalb der Höhenerstreckung der auf der Platine angeordneten Kondensatoren erzielt werden.

Der Metallkörper ist gemäß einer bevorzugten Ausführungsform als Hülse ausgebildet, wobei die Stromschiene mittels einer Verschraubung mit der Hülse verbunden ist. Die Stromschienen werden somit mittels der Verschraubungen an der Hülse befestigt und auf die Hülsen gepresst, wodurch auf einfache und kostengünstige Weise eine elektrische Kontaktierung der Stromschienen mit den Hülsen und Befestigung der Stromschienen an den Hülsen erzielbar ist. Durch die Anordnung der Stromschienen oberhalb der Platine des Gleichspannungszwischenkreises wird hierbei eine gute Zugänglichkeit der Verschraubungen für eine einfache Montage erzielt.

Der Metallkörper kann hierbei zur elektrischen Kontaktierung mit den stromführenden Leiterbahnen der Leiterplatte des Leistungsmoduls verlötet sein. Eine Lötverbindung ermöglicht mit geringem Herstellungsaufwand eine elektrische Kontaktierung der Metallkörper mit der Leiterplatte des Leistungsmoduls und eine Befestigung der Metallkörper auf der Leiterplatte.

Hinsichtlich eines geringen Bauaufwandes und eines einfachen Aufbaus ergeben sich Vorteile, wenn der von einer Hülse gebildete Metallkörper gemäß einer bevorzugten Ausgestaltungsform der Erfindung mittels der Verschraubungen mit der Leiterplatte des Leistungsmoduls verpressbar ist. Hierdurch kann von der bereits vorhandenen Verschraubung zur Befestigung der Stromschiene an der Hülse ebenfalls die Hülse an der Leiterplatte befestigt und mit der Leiterplatte elektrisch kontaktiert werden.

Die Kühlung der Leistungshalbleiter des Leistungsmoduls kann auf einfache Weise sichergestellt werden, wenn gemäß einer vorteilhaften Weiterbildung der Erfindung die Leiterplatte mit einer der Platine gegenüberliegenden Unterseite an einem Kühlkörper anliegt.

Ein besonders einfacher Aufbau mit einem geringen Montageaufwand des erfindungsgemäßen Umrichters ist hierbei erzielbar, wenn die Verschraubung als elektrisch isolierter Verschraubungen ausgebildet ist und die Leiterplatte des Leistungsmoduls gemäß einer bevorzugten Ausgestaltungsform der Erfindung mittels der Verschraubung an dem Kühlkörper befestigbar ist. Die elektrisch isolierten Verschraubungen erfüllen somit eine Doppelfunktion und dienen einerseits zur Befestigung der Stromschienen an den Hülsen und somit zur elektrischen Kontaktierung der Stromschienen sowie gegebenenfalls weiterhin zur elektrischen Kontaktierung der Leiterplatte mit den Hülsen und somit zur elektrischen Kontaktierung der Hülsen mit der Leiterplatte des Leistungsmoduls und andererseits zur mechanischen Befestigung der Leiterplatte auf dem Kühlkörper. Durch diese Doppelfunktion der Verschraubungen sind keine zusätzlichen Befestigungsmittel zur Befestigung des Leistungsmoduls an dem Kühlkörper erforderlich. Mit den Verschraubungen lassen sich die Befestigung und elektrische Kontaktierung der Stromschienen und die Befestigung des Leistungsmoduls an dem Kühlkörper in kostengünstiger Weise bei geringem Montageaufwand und platzsparend realisieren.

Das Leistungsmodul erwärmt sich aufgrund der Abwärme der Leistungshalbleiter, wodurch ein Bi-Metall-Effekt auftritt, der zu einem Abheben der Leiterplatte vom Kühlkörper führen kann. Um ein derartiges Abheben des Leistungsmoduls von dem Kühlkörper zu vermeiden, ist gemäß einer vorteilhaften Weiterbildung der Erfindung zur Anpressung der Leiterplatte an dem Kühlkörper ein Druckrahmen vorgesehen. Bevorzugt steht der Druckrahmen mit dem Umfang der Leiterplatte in Wirkverbindung, wodurch bei dem erfindungsgemäßen Umrichter, bei dem die Leiterplatte des Leitungsmoduls über die Verschraubungen der zwischen den Kondensatoren des Gleichspannungszwischenkreises angeordneten Stromschienen am Kühlkörper befestigt ist, ein Abheben der Leiterplatte des Leistungsmoduls am Außenumfang sicher vermieden werden kann und somit eine wirksame Kühlung erzielt werden kann.

Der Druckrahmen ist gemäß einer bevorzugten Ausführungsform der Erfindung mittels mindestens einer Schraubverbindung an dem Kühlkörper befestigbar, wodurch mit geringem zusätzlichem Montageaufwand und Bauaufwand eine Befestigung des Druckrahmens an dem Kühlkörper und somit eine umfangsseitige Anpressung des Leistungsmoduls an dem Kühlkörper erzielt wird.

Bevorzugt ist ein den Umrichter abdeckender Deckel vorgesehen, der mittels der Schraubverbindung an dem Druckrahmen befestigbar ist. Die Schraubverbindung des Druckrahmens erfüllt somit ebenfalls eine Doppelfunktion zur Befestigung des Druckrahmens an dem Kühlkörper und zur Befestigung des Deckels an dem Druckrahmen, so dass sich der Montageaufwand und der Bauaufwand weiter verringern lassen.

Weitere Vorteile und Einzelheiten der Erfindung werden anhand der in den schematischen Figuren dargestellten Ausführungsbeispiele näher erläutert. Hierbei zeigt
- Figur 1: eine perspektivische Explosionsdarstellung des erfindungsgemäßen Umrichters,
- Figur 2: den Umrichter in einer weiteren Explosionsdarstellung,
- Figur 3: einen Schnitt entlang der Linie A-A der Figur 1,
- Figur 4: einen Schnitt entlang der Line B-B der Figur 1 mit angebauter Stromschiene und Kühlkörper und
- Figur 5: eine Detailansicht des Umrichters mit einem umfangsseitig angeordneten Druckrahmen.

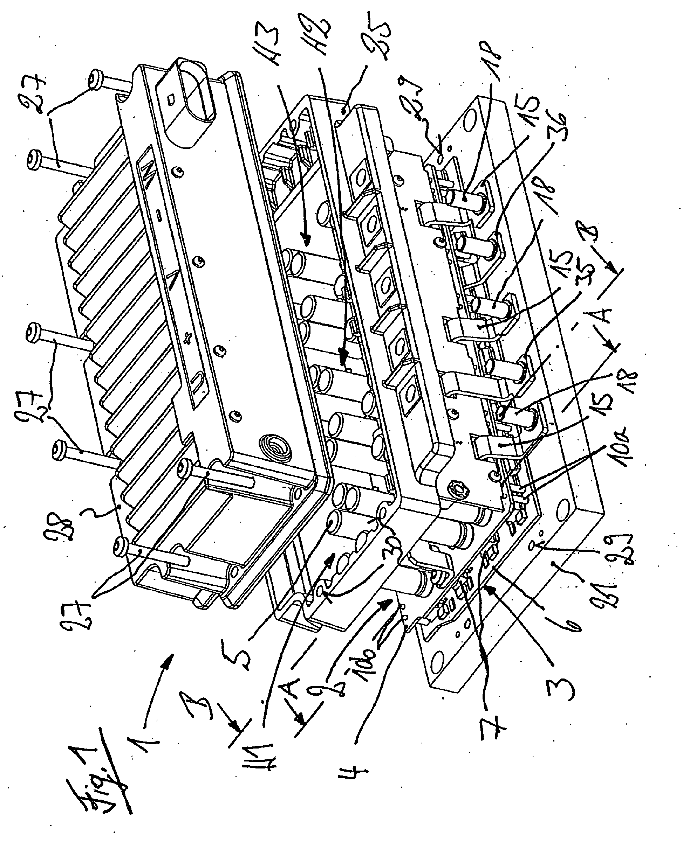

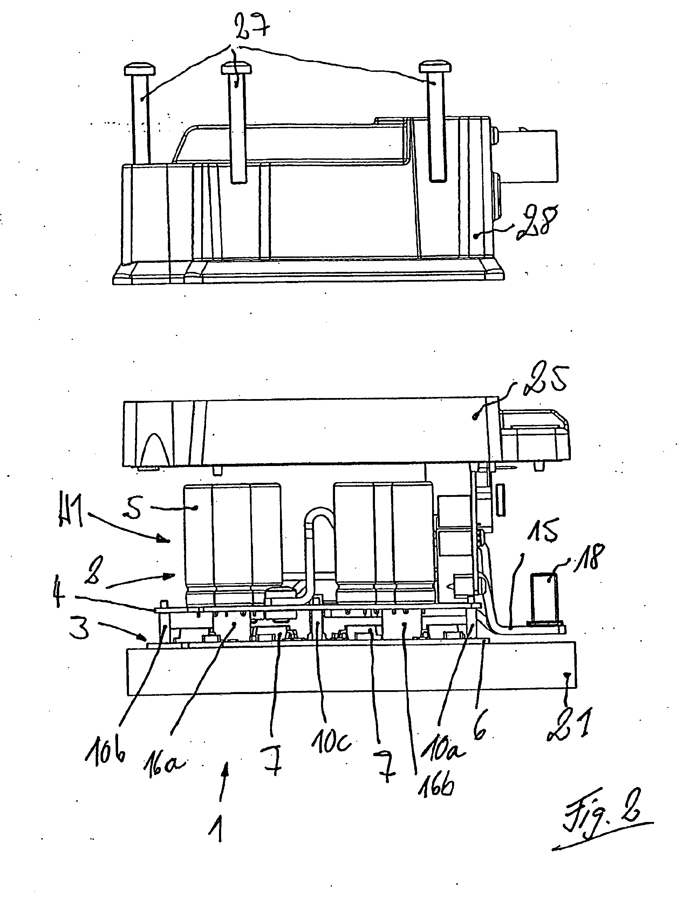

In den Figuren 1 und 2 ist ein Umrichter 1, beispielsweise ein dreiphasiger Drehstromumrichter als Frequenzumrichter, zur Ansteuerung eines elektrischen Motors dargestellt.

Der Umrichter 1 weist einen Gleichspannungszwischenkreis 2 und ein Leistungsmodul 3 auf. Der Gleichspannungszwischenkreis 2 ist von einer plattenförmigen Platine 4 gebildet, die mit Kondensatoren 5 versehen ist. Das Leistungsmodul 3 ist von einer Leiterplatte 6, bevorzugt einer IMS-Leiterplatte, gebildet, die mit Leistungshalbleitern 7, beispielsweise Leistungstransistoren, und weiteren diskreten Bauteilen bestückt ist.

Der erfindungsgemäße Umrichter 1 weist einen Aufbau mit drei identischen Halbbrücken H1, H2, H3 auf, die jeweils von mehreren Leitungshalbleitern 7 gebildet werden können.

Die Leistungshalbleiter 7 des Leistungsmoduls 3 sind jeweils mit einem Minuspol und einem Pluspol des Gleichspannungszwischenkreises 2 verbunden. Die Leistungshalbleiter 7 einer Halbbrücke H1 bzw. H2 bzw. H3 sind jeweils zu einem der drei stromführenden Motorphasenausgänge zusammengeschlossen.

Bei dem erfindungsgemäßen Umrichter 1 sind die Platine 4 des Gleichspannungszwischenkreises 2 und die Leiterplatte 6 des Leistungsmoduls 3 sandwichartig übereinander angeordnet, wobei die Platine 4 des Gleichspannungszwischenkreises 2 direkt oberhalb der Leiterplatte 6 des Leistungsmoduls 3 in einer weiteren parallelen Ebene angeordnet ist. Zur elektrischen Kontaktierung und mechanischen Verbindung des Gleichspannungszwischenkreises 2 und des Leistungsmoduls 3 sind mehrere oberflächenmontierte Lötstifte 10a, 10b, 10c vorgesehen.

In den Figuren 1 und 2 ist weiterhin ein Kühlkörper 21, ein Druckrahmen 25 und ein Deckel 28 dargestellt, die später genauer beschrieben werden.

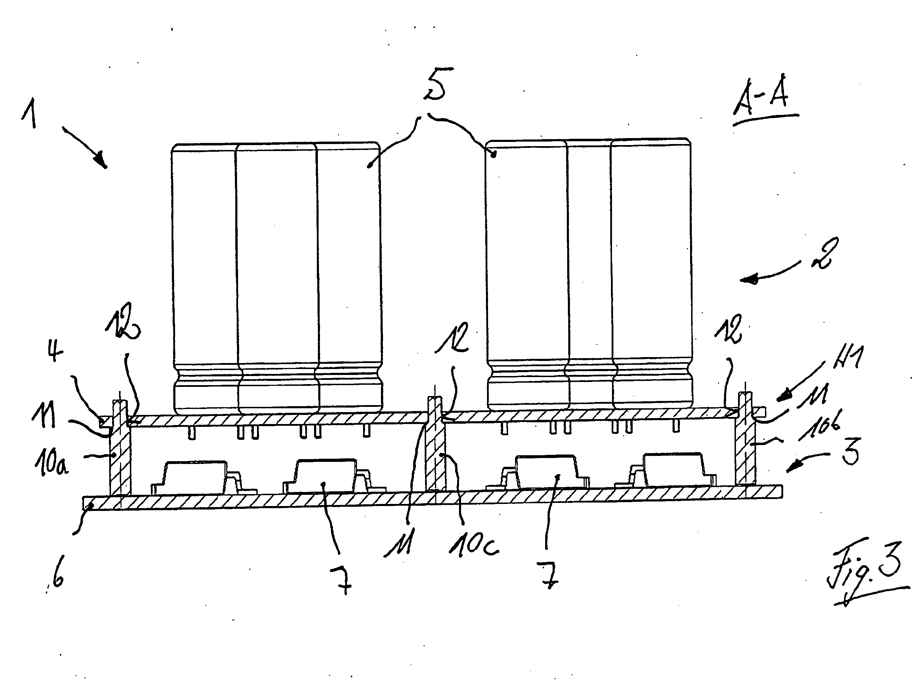

Wie aus der Figur 3 ersichtlich ist, sind die Lötstifte 10a bzw. 10b hierbei an den Außenseiten, beispielsweise den Längsseiten, des Umrichters 1 symmetrisch angeordnet, wobei die Lötstifte 10a und 10b beispielsweise den Pluspol bilden. In einer Längsmittelebene des Umrichters 3 sind weitere Lötstifte 10c angeordnet, die beispielsweise den Minuspol bilden.

Zur elektrischen Kontaktierung einer Steuerleitung der Leistungshalbleiter 7 in der Leiterplatte 6 des Leistungsmoduls 3 können nicht näher dargestellte Steckverbindungen vorgesehen werden.

Die Lötstifte 10a, 10b, 10c sind an der Oberseite der Leiterplatte 6 des Leistungsmodul 3 angeordnet und in der Leiterplatte 6 bestückt, bevorzugt mit der Leiterplatte 6 verlötet, wodurch diese mit entsprechenden stromführenden Leiterbahnen der Platine 6 elektrisch kontaktiert sind und an der Leiterplatte 6 befestigt sind. Die Lötstifte 10a, 10b, 10c weisen am oberen Ende einen Durchmesserabsatz 11 auf, wobei sich die Lötstifte 10a, 10b, 10c mit dem verringerten Durchmesser durch eine an den Durchmesser der Lötstifte angepasste Aufnahmebohrung 12 der Platine 4 des Gleichspannungszwischenkreises 2 erstrecken. Hierdurch kann die Platine 4 mit geringem Montageaufwand auf die oberflächenmontierten Lötstifte 10a, 10b, 10c mit den Aufnahmebohrungen 12 aufgesteckt werden und an den Durchmesserabsätzen 11 der Lötstifte 10a, 10b, 10c im Abstand zu der Leiterplatte 6 gehalten werden. Durch Verlöten der Lötstifte 10a, 10b, 10c mit entsprechenden Leiterbahnen der Platine 4 des Gleichstromzwischenkreises 2 kann die elektrische Kontaktierung der Lötstifte 10a, 10b, 10c mit der Platine 4 und die mechanische Verbindung der Platine 4 mit der Leiterplatte 6 auf einfache Weise hergestellt werden.

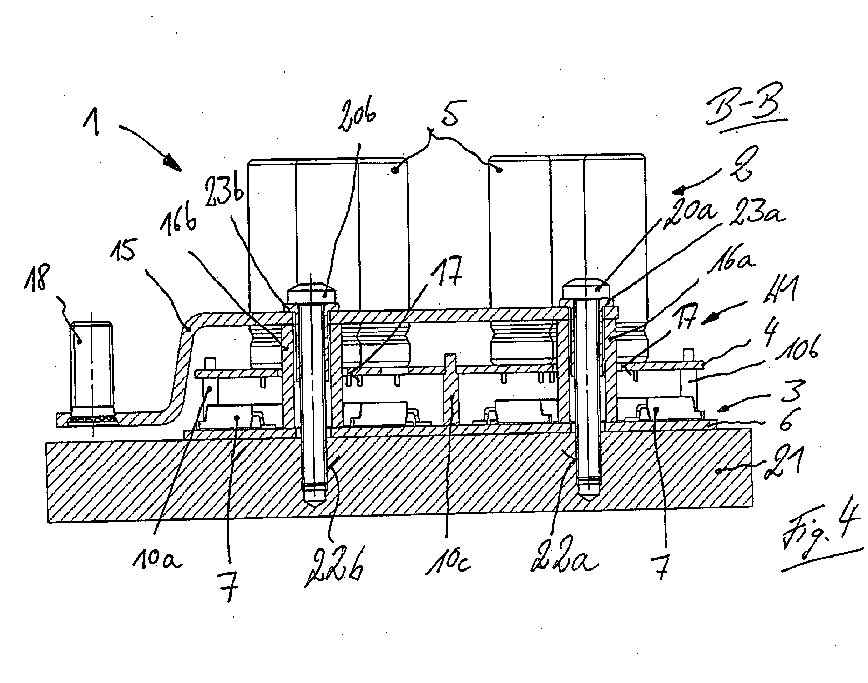

Die drei Phasenabgänge der Motorphasen und somit die Leistungsstromanschlüsse des erfindungsgemäßen Umrichters 1 werden - wie aus der Figur 1 ersichtlich ist - von jeweils einer streifenförmigen Stromschiene 15 gebildet, von denen in der Figur 4 der Phasenabgang der Halbbrücke H1 dargestellt ist. Die Phasenabgänge der Halbbrücken H2 und H3 sind - wie aus der Figur 1 ersichtlich ist - identisch aufgebaut.

Die von einem flachstahlförmigen, beispielsweise Kupfer- oder Stahlbauteil, gebildete Stromschiene 15 ist bei dem erfindungsgemäßen Umrichter 1 oberhalb der Platine 4 des Gleichspannungszwischenkreises 2 in einer weiteren parallelen Ebene angeordnet und steht mittels mindestens eines von einer Hülse gebildeten elektrisch leitenden Metallkörpers 16a, 16b mit den Ausgängen der zugeordneten Leistungshalbleiter 7 der entsprechenden Halbbrücke H1, H2 bzw. H3 in Verbindung. Die Stromschienen 15 sind hierbei innerhalb der Höhenerstreckung der Kondensatoren 5 des Gleichspannungszwischenkreises 2 angeordnet.

Die Platine 4 des Gleichspannungszwischenkreises 2 ist zur isolierenden Durchführung der Metallkörper 16a, 16b mit jeweils einer entsprechenden bohrungsförmigen Ausnehmung 17 versehen, deren Durchmesser größer als der Außendurchmesser der Hülsen ist. Die von den Hülsen gebildeten Metallkörper 16a, 16b stehen hierbei mit der unteren Stirnseite mit stromführenden Leiterbahnen der Leiterplatte 6 des Leistungsmoduls 3 in Kontakt. Auf die obere Stirnseite der von den Hülsen gebildeten Metallkörper 16a, 16b ist die entsprechende Stromschiene 15 aufgesetzt.

Wie in Verbindung mit der Figur 1 ersichtlich ist, ist die Stromschiene 15 zwischen den Kondensatoren 5 der jeweiligen Halbbrücken H1, H2, H3 angeordnet und an dem in der Figur 4 linken Seite aus dem Umrichteraufbau seitlich herausgeführt und an dem herausragenden Ende mit einem Anschluss 18, insbesondere einem Bolzen, für einen Leistungsstromabgriff als Motorphasenabgang versehen.

In dem seitlich herausgeführten Bereich ist die Stromschiene 15 nach unten in Richtung der Platine 4 und der Leiterplatte 6 abgekröpft, um eine platzsparende Anordnung der Anschlüsse 18 innerhalb der Höhenerstreckung des Umrichters 1 zu erzielen.

Zur Befestigung der Stromschiene 15 auf den Metallkörpern 16a, 16b ist jeweils eine Verschraubung 20a, 20b vorgesehen, mit der die Stromschiene 15 an den Metallkörpern 16a, 16b befestigt und elektrisch kontaktiert wird. Die Metallkörper 16a, 16b sind hierbei bevorzugt mit der Leiterplatte 6 des Leistungsmoduls 3 verlötet. Die Verschraubung 20a, 20b ist hierbei in einer Aufnahmebohrung der Hülse konzentrisch zu der Hülse angeordnet.

In der Figur 4 ist weiterhin ein Kühlkörper 21 des erfindungsgemäßen Umrichters 1 dargestellt, auf dem die Leiterplatte 6 des Leistungsmoduls 3 zu dessen Kühlung mit der den Leistungshalbleitern 7 gegenüberliegenden Unterseite aufliegt.

Bei dem erfindungsgemäßen Umrichter 1 weisen die Verschraubungen 20a, 20b eine Doppelfunktion auf und dienen neben der Verpressung der Stromschienen 15 mit den Metallkörpern 16a, 16b und somit der Funktion Befestigung der Stromschienen 15 und elektrischer Kontaktierung der Motorphasenabgänge weiterhin zur Funktion Befestigung und Verpressung des Leistungsmoduls 3 auf dem Kühlkörper 21.

Die Verschraubungen 20a, 20b sind hierbei jeweils von elektrisch isolierten Schrauben gebildet, die sich durch die von den Hülsen gebildeten Metallkörper 16a, 16b erstrecken und in entsprechende Gewindeaufnahmen 22a, 22b des Kühlkörpers 21 eingeschraubt werden können. Zur Isolation der Verschraubungen 20a, 20b ist jede Verschraubung 20a, 20b mit einer Isolationshülse 23a, 23b versehen, die zwischen dem Schraubenkopf der Verschraubung 20a, 20b und der Oberseite der Stromschiene 15 eingespannt ist und sich nach unten in die Hülse erstreckt, um den Schraubenkopf und den Schraubenschaft der Verschraubung 20a, 20b gegenüber der Stromschiene 15 und dem entsprechenden Metallkörper 16a bzw. 16b elektrisch zu isolieren.

Durch das Verschrauben der Verschraubungen 20a, 20b in dem Kühlkörper 21 können weiterhin von den Verschraubungen 20a, 20b die Metallkörper 16a, 16b mit der unteren Stirnseite an die stromführenden Leiterbahnen der Leiterplatte 6 alternativ zu einer Lötverbindung gepresst werden, wodurch von den Verschraubungen 20a, 20b zusätzlich die elektrische Kontaktierung der Metallkörper 16a 16b mit der Leiterplatte 6 des Leistungsmoduls 3 und somit die elektrische Kontaktierung der Motorphasenabgänge erzielt wird.

Wie aus der Figur 1 ersichtlich ist, erfolgt der Anschluss des Gleichspannungszwischenkreises 2 an den Pluspol und den Minuspol ebenfalls über streifenförmigen Stromschiene 35, 36, die im Aufbau den Stromschienen 15 der drei Motorphasenabgänge ähnlich sind. Die beispielsweise den Pluspol bildenden Stromschiene 35 ist hierbei zwischen den Kondensatoren der benachbarten Halbbrücken H1 und H2 angeordnet. Die den Minuspol bildenden Stromschiene 36 ist zwischen den Kondensatoren der benachbarten Halbbrücken H2 und H3 angeordnet. Die Stromschienen 35, 36 sind zur selben Seite wie die Stromschienen 15 seitlich aus dem Umrichteraufbau herausgeführt und in dem seitlich herausgeführten Bereich ebenfalls nach unten in Richtung der Platine 4 und der Leiterplatte 6 abgekröpft, um eine platzsparende Anordnung der entsprechenden Anschlüsse des Pluspols und Minuspols innerhalb der Höhenerstreckung des Umrichters 1 zu erzielen.

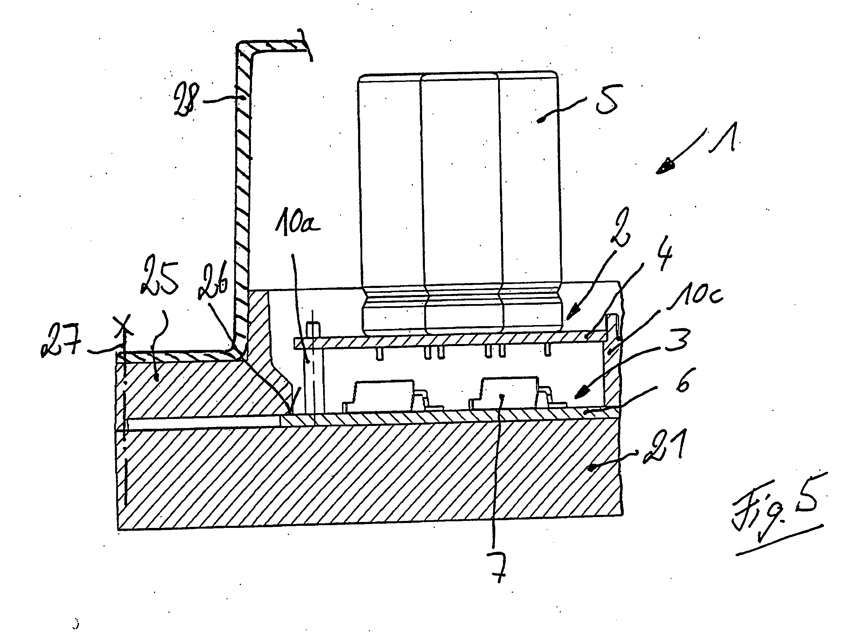

Durch die Verschraubungen 20a, 20b und die von den Hülsen gebildeten Metallkörper 16a, 16b kann eine flächige Verpressung der Leiterplatte 6 auf den Kühlkörper 21 um den Bereich der Hülsen im inneren Bereich der Leiterplatte 6 erzielt werden. Um bei einer Erwärmung des Leistungsmoduls 3 ein Abheben des Leiterplatte 6 von dem Kühlkörper 21 zu vermeiden, ist der erfindungsgemäße Umrichter 1 - wie in der Figur 5 dargestellt ist - mit dem Druckrahmen 25 zur zusätzlichen Anpressung des Leistungsmoduls 3 an dem Kühlkörper 21 versehen, um ein vollflächiges Anliegen der Leiterplatte 6 auf dem Kühlkörper 21 sicherzustellen. Der Druckrahmen 25 steht hierbei mit dem Außenumfang der Leiterplatte 6 des Leistungsmodul 3 in Wirkverbindung und ist mit mindestens einer entsprechenden, insbesondere einer rahmenartig umlaufenden, Haltenase 26 versehen, die mit der Oberseite der Leiterplatte 6 an deren Außenumfang zusammenwirkt. Die Haltenase 26 an dem rahmenartigen Druckrahmen 25 kann hierbei im Bereich der drei Stromschienen 15 sowie der Stromschienen 35, 36 unterbrochen sein. Die Befestigung des Druckrahmens 25 an dem Kühlkörper 21 und somit die zusätzliche umfangsseitige Verpressung des Leistungsmoduls 3 auf den Kühlkörper 21 kann über die in den Figuren 1 und 2 näher dargestellten Schraubverbindungen 27 erfolgen, die sich durch Durchgangsbohrungen 30 des Druckrahmens 25 erstrecken und in entsprechende Gewindebohrungen 29 des Kühlkörpers 21 eingeschraubt werden können.

Über die Schraubverbindungen 27 kann weiterhin - wie in den Figuren 1, 2 und 5 verdeutlicht ist - der Deckel 28 an dem Druckrahmen 25 befestigt werden, der den Umrichter 1 nach oben abdeckt. Die Schraubverbindungen 27 sind bevorzugt an den Eckbereichen bzw. den Stirn- und/oder Längsseiten des rahmenartig umlaufenden Druckrahmens 25 angeordnet, wodurch mit einer geringen Anzahl von Schraubverbindungen 27 und einem entsprechend geringen Montageaufwand ein umfangsseitiges Verpressen der Leiterplatte 6 auf dem Kühlkörper 21 und gegebenenfalls eine Befestigung des Deckels 28 erzielt wird.

Der erfindungsgemäße Umrichter 1 weist eine Reihe von Vorteilen auf. Durch die Anordnung der Platine 4 des Gleichspannungszwischenkreise 2 direkt oberhalb der Platine 6 des Leistungsmoduls 3 und die Verwendung von oberflächenmontierten Lötstiften 10a, 10b,10c zur elektrischen und mechanischen Verbindung des Leistungsmoduls 3 mit dem Gleichspannungszwischenkreis 2 kann der Abstand des Leistungsmoduls 3 von dem Gleichspannungszwischenkreis 2 minimiert werden, um einen verbesserten induktionsarmen Aufbau mit minimierten Streuinduktivitäten zu erzielen. Die Lötstifte 10a, 10b, 10c können vollautomatisch bestückt werden, wodurch der Monatageaufwand vermindert wird. Die Doppelfunktion der Lötstifte 10a, 10b, 10c zur mechanischen und elektrischen Verbindung des Gleichspannungszwischenkreises 2 mit dem Leistungsmodul 3 ergibt einen einfachen und kostengünstigen Aufbau. Durch die elektrisch isolierten Verschraubungen 20a, 20b und deren Doppelfunktion können die Motorphasenabgänge des Leistungsmoduls 3, die von den Stromschienen 15 und den Metallkörper 16a, 16b gebildet werden, und die mechanische Befestigung des Leistungsmoduls 3 an dem Kühlkörper 21 mit geringem Herstellaufwand in kostengünstiger Weise realisiert werden, wobei weiterhin eine einfache Montage erzielt wird. Die Anordnung der Stromschienen 15 oberhalb der Platine 4 des Gleichspannungskreises 2 zwischen den Kondensatoren 5 des Gleichspannungszwischenkreises ermöglicht eine platzsparende Anordnung der Motorphasenabgänge mit einem geringen Bauraumbedarf des erfindungsgemäßen Umrichters 1 und erleichtert über die gute Zugänglichkeit der Verschraubungen 20a, 20b die Montage des erfindungsgemäßen Umrichters 1 weiter. Gleiches gilt für die Anordnung und Befestigung der den Pluspol und den Minuspol bildenden Stromschienen 35, 36. Über den Druckrahmen 25 ist eine einfache umfangsseitige Anpressung des Leistungsmoduls 3 an dem Kühlkörper 21 zur wirksamen Kühlung des Umrichters 1 erzielbar. In Verbindung mit den im inneren Bereich der Leiterplatte 6 angeordneten Verschraubungen 20a, 20b kann mit dem Druckrahmen 25 eine vollflächiges Anliegen der Leiterplatte 6 auf dem Kühlkörper 21 erzielt werden und ein Abheben der Leiterplatte 6 von dem Kühlkörper 21 verhindert werden. Über die Schraubverbindungen 27 des Druckrahmens 25 kann weiterhin ein den Umrichter 1 abdeckender Deckel 28 auf einfache Weise an dem Druckrahmen 25 befestigt werden. Durch den erfindungsgemäßen mechanischen Aufbau des Umrichters 1 können einfache und kostengünstige Löttechnologien verwendet werden, wodurch die Herstellung weiter vereinfacht und verbilligt wird.

## Patentansprüche

1. Umrichter, insbesondere mehrphasiger Drehstromumrichter, mit einem Gleichspannungszwischenkreis und einem mindestens einen Leistungshalbleiter aufweisenden Leistungsmodul, wobei der Gleichspannungszwischenkreis (2) von einer plattenförmigen Platine (4) und das Leistungsmodul (3) von einer Leiterplatte (6) gebildet sind, die in parallelen Ebenen direkt übereinander angeordnet sind und mittels Lötstiften (10a; 10b; 10c) elektrisch und mechanisch miteinander verbunden sind,
**dadurch gekennzeichnet,**
**dass** Leistungsstromanschlüsse von Stromschienen (15) gebildet sind, die jeweils an einem Metallkörper (16a,16b) befestigt sind und über diesen Metallkörper (16a; 16b) mit der Leiterplatte (6) elektrisch verbunden sind und die Stromschienen (15) oberhalb der Platine (4) angeordnet sind, wobei sich der Metallkörper (16a; 16b) durch jeweils eine Ausnehmung (17) der Platine (4) erstreckt, so dass die Stromschiene in einer weiteren parallelen Ebene oberhalb der Platine angeordnet ist.

2. Umrichter nach Anspruch 1, **dadurch gekennzeichnet, dass** die Lötstifte (10a; 10b; 10c) an der der Platine (4) zugewandten Oberseite der Leiterplatte (6) montiert sind und sich durch Aufnahmebohrungen (12) der Platine (4) erstrecken, wobei die Lötstifte (10a; 10b; 10c) einen Durchmesserabsatz (11) zur Halterung der Platine (4) aufweisen.

3. Umrichter nach Anspruch 1 oder 2, **dadurch gekennzeichnet, dass** die Leiterplatte (6) als IMS-Leiterplatte ausgebildet ist, die mit den Leistungshalbleitern (7) bestückt ist.

4. Umrichter nach einem der Ansprüche 1 bis 3, **dadurch gekennzeichnet, dass** die Stromschienen (15) zwischen Kondensatoren (5) des Gleichspannungszwischenkreises (2) angeordnet sind, die an der Platine (4) angeordnet sind.

5. Umrichter nach einem der Ansprüche 1 bis 4, **dadurch gekennzeichnet, dass** der Metallkörper (16a; 16b) als Hülse ausgebildet sind, wobei die Stromschiene (15) mittels einer Verschraubung (20a; 20b) mit der Hülse verbunden ist.

6. Umrichter nach einem der Ansprüche 1 bis 5, **dadurch gekennzeichnet, dass** der Metallkörper (16a; 16b) mit der Leiterplatte (6) des Leistungsmoduls (3) verlötet ist.

7. Umrichter nach Anspruch 5, **dadurch gekennzeichnet, dass** der von der Hülse gebildete Metallkörper (16a; 16b) mittels der Verschraubung (20a; 20b) mit der Leiterplatte (6) des Leistungsmoduls (3) verpressbar ist.

8. Umrichter nach einem der Ansprüche 1 bis 7, **dadurch gekennzeichnet, dass** die Leiterplatte (6) mit einer der Platine (4) gegenüberliegenden Unterseite an einem Kühlkörper (21) anliegt.

9. Umrichter nach Anspruch 8 und nach Anspruch 7, **dadurch gekennzeichnet, dass** die Verschraubung (20a; 20b) als elektrisch isolierte Verschraubung (20a, 20b) ausgebildet ist und die Leiterplatte (6) des Leistungsmoduls (2) mittels der Verschraubung (20a; 20b) an dem Kühlkörper (21) befestigbar ist, wobei eine Isolationshülse (23a, 23b) zwischen einem Schraubenkopf der Verschraubung (20a, 20b) und einer Oberseite der Stromschiene (15) eingespannt ist und sich nach unten in die Hülse erstreckt, um den Schraubenkopf und den Schraubenschaft der Verschraubung (20a, 20b) gegenüber der Stromschiene (15) und dem entsprechenden Metallkörper (16a,16b) elektrisch zu isolieren.

10. Umrichter nach einem der Ansprüche 1 bis 9, **dadurch gekennzeichnet, dass** zur Anpressung der Leiterplatte (6) an dem Kühlkörper (10) ein Druckrahmen (25) vorgesehen ist.

11. Umrichter nach Anspruch 10, **dadurch gekennzeichnet, dass** der Druckrahmen (25) mit dem Umfang der Leiterplatte (6) in Wirkverbindung steht.

12. Umrichter nach Anspruch 11, **dadurch gekennzeichnet, dass** der Druckrahmen (25) mittels mindestens einer Schraubverbindung (27) an dem Kühlkörper (10) befestigbar ist.

13. Umrichter nach Anspruch 12, **dadurch gekennzeichnet, dass** ein den Umrichter (1) abdeckender Deckel (28) vorgesehen ist, der mittels der Schraubverbindung (27) an dem Druckrahmen (25) befestigbar ist.

## Claims

1. Converter, in particular polyphase AC converter, comprising a DC link and a power module having at least one power semiconductor, wherein the DC link (2) is formed by a plate-shaped circuit board (4) and the power module (3) is formed by a printed circuit board (6), which circuit board and printed circuit board are arranged in parallel planes directly one above the other and are electrically and mechanically connected to one another by means of solder pins (10a; 10b; 10c), **characterized in that** electrical power connections are formed by busbars (15), which are each fastened on a metal body (16a, 16b) and are electrically connected via said metal body (16a, 16b) to the printed circuit board (6), and the busbars (15) are arranged above the circuit board (4), wherein the metal body (16a, 16b) extends through in each case one cutout (17) in the circuit board (4) so that the busbar is arranged in a further parallel plane above the circuit board.

2. Converter according to Claim 1, **characterized in that** the solder pins (10a; 10b; 10c) are fitted on the upper side of the printed circuit board (6) which faces the circuit board (4) and extend through receiving bores (12) in the circuit board (4), wherein the solder pins (10a; 10b; 10c) have a diameter shoulder (11) for holding the circuit board (4).

3. Converter according to Claim 1 or 2, **characterized in that** the printed circuit board (6) is in the form of an IMS printed circuit board, which is populated with the power semiconductors (7).

4. Converter according to one of Claims 1 to 3, **characterized in that** the busbars (15) are arranged between capacitors (5) of the DC link (2), said capacitors being arranged on the circuit board (4).

5. Converter according to one of Claims 1 to 4, **characterized in that** the metal body (16a; 16b) is in the form of a sleeve, wherein the busbar (15) is connected to the sleeve by means of a screw joint (20a; 20bd).

6. Converter according to one of Claims 1 to 5, **characterized in that** the metal body (16a; 16b) is soldered to the printed circuit board (6) of the power module (3).

7. Converter according to Claim 5, **characterized in that** the metal body (16a; 16b) formed by the sleeve can be compressed with the printed circuit board (6) of the power module (3) by means of the screw joint (20a; 20b).

8. Converter according to one of Claims 1 to 7, **characterized in that** the printed circuit board (6) rests with a lower side opposite the circuit board (4) against a heat sink (21).

9. Converter according to Claim 8 and according to Claim 7, **characterized in that** the screw joint (20a; 20b) is in the form of an electrically insulated screw joint (20a, 20b), and the printed circuit board (6) of the power module (2) can be fastened on the heat sink (21) by means of the screw joint (20a; 20b), wherein an insulating sleeve (23a, 23b) is clamped in between a screw head of the screw joint (20a, 20b) and an upper side of the busbar (15) and extends downwards into the sleeve in order to electrically insulate the screw head and the screw shaft of the screw joint (20a; 20b) from the busbar (15) and the corresponding metal body (16a, 16b).

10. Converter according to one Claims 1 to 9, **characterized in that** a pressure frame (25) is provided for pressing the printed circuit board (6) against the heat sink (10).

11. Converter according to Claim 10, **characterized in that** the pressure frame (25) is operatively connected to the circumference of the printed circuit board (6).

12. Converter according to Claim 11, **characterized in that** the pressure frame (25) can be fastened to the heat sink (10) by means of at least one screw connection (27).

13. Converter according to Claim 12, **characterized in that** a cover (28) is provided which covers the converter (1) and can be fastened to the pressure frame (25) by means of the screw connection (27).

## Revendications

1. Convertisseur, en particulier convertisseur polyphasé pour courants tournants, présentant un circuit intermédiaire à tension continue et un module de puissance qui présente au moins un semi-conducteur de puissance,
le circuit intermédiaire (2) à tension continue étant formé par une carte de circuit (4) et le module de puissance (3) par une carte de circuit (6) disposées directement l'une au-dessus de l'autre dans des plans parallèles et raccordées l'une à l'autre électriquement et mécaniquement par des tiges brasées (10a; 10b; 10c), **caractérisé en ce que**
les bornes de raccordement de courant de puissance sont formées par des rails de courant (15) fixés sur un corps métallique (16a, 16b) et raccordés électriquement à la carte de circuit (6) par ce corps métallique (16a; 16b) et
**en ce que** les rails de courant (15) sont disposés au-dessus de la carte de circuit (4), le corps métallique (16a; 16b) traversant une découpe (17) ménagée dans la carte de circuit (4) de telle sorte que le rail de courant est disposé au-dessus de la carte de circuit, dans un autre plan parallèle.

2. Convertisseur selon la revendication 1, **caractérisé en ce que** les tiges brasées (10a; 10b; 10c) sont montées sur le côté supérieur de la carte de circuit (6) tourné vers la carte de circuit (4) et s'étendent dans des alésages de réception (12) de la carte de circuit (4), les tiges brasées (10a; 10b; 10c) présentant un décalage (11) de leur diamètre pour maintenir la carte de circuit (4).

3. Convertisseur selon les revendications 1 ou 2, **caractérisé en ce que** la carte de circuit (6) est configurée comme carte de circuit IMS équipée des semi-conducteurs de puissance (7).

4. Convertisseur selon l'une des revendications 1 à 3, **caractérisé en ce que** les rails de courant (15) sont disposés entre des condensateurs (5) du circuit intermédiaire (2) à courant continu, disposés sur la carte de circuit (4).

5. Convertisseur selon l'une des revendications 1 à 4, **caractérisé en ce que** le corps métallique (16a; 16b) est configuré comme douille, le rail de courant (15) étant raccordé à la douille au moyen d'un filet (20a; 20b).

6. Convertisseur selon l'une des revendications 1 à 5, **caractérisé en ce que** le corps métallique (16a; 16b) est brasé sur la carte de circuit (6) du module de puissance (3).

7. Convertisseur selon la revendication 5, **caractérisé en ce que** le corps métallique (16a; 16b) formé par la douille peut-être comprimé sur la carte de circuit (6) du module de puissance (3) au moyen du filet (20a; 20b).

8. Convertisseur selon l'une des revendications 1 à 7, **caractérisé en ce que** la carte de circuit (6) est placée sur un corps de refroidissement (21) par son côté inférieur opposé à la carte de circuit (4).

9. Convertisseur selon la revendication 8 et selon la revendication 7, **caractérisé en ce que** le filet (20a; 20b) est configuré comme filet (20a; 20b) électriquement isolé et **en ce que** la carte de circuit (6) du module de puissance (2) peut être fixée sur le corps de refroidissement (21) au moyen du filet (20a; 20b), une douille d'isolation (23a; 23b) étant serrée entre une tête de vis du filet (20a; 20b) et le côté supérieur du rail de courant (15) et s'étendant vers le bas dans la douille pour isoler électriquement la tête de la vis et la tige de la vis du filet (20a; 20b) vis-à-vis du rail de courant (15) et du corps métallique (16a, 16b) correspondant.

10. Convertisseur selon l'une des revendications 1 à 9, **caractérisé en ce qu'**un cadre de compression (25) est prévu pour repousser la carte de circuit (6) sur le corps de refroidissement (10).

11. Convertisseur selon la revendication 10, **caractérisé en ce que** le cadre de compression (25) coopère avec la périphérie de la carte de circuit (6).

12. Convertisseur selon la revendication 11, **caractérisé en ce que** le cadre de compression (25) peut être fixé sur le corps de refroidissement (10) au moyen d'au moins une liaison filetée (27).

13. Convertisseur selon la revendication 12, **caractérisé en ce qu'**un couvercle (28) qui recouvre le convertisseur (1) est prévu et peut être fixé sur le cadre de compression (25) au moyen de la liaison filetée (27).
